# EUROPEAN PATENT APPLICATION

(11) **EP 3 627 038 A1**
(43) Date of publication of application: **25.03.2020**
(21) Application number: 17910440.1
(22) Date of filing: 18.12.2017
(51) Int. Cl.: F21V 8/00, G02B 6/02

(54) **PHOTOVOLTAIC POWER GENERATION UNIT USING OPTICAL FIBERS, AND POWER GENERATION SYSTEM APPLYING SAME**

(30) Priority: 18.05.2017 KR 20170061730; 16.06.2017 KR 20170076827; 27.11.2017 KR 20170159690; 27.11.2017 KR 20170159691; 27.11.2017 KR 20170159692
(71) Applicant: Bae, Suk Man, Yongin-si, Gyeonggi-do 17079 (KR)
(72) Inventor: BAE, Suk Man, Gyeonggi-do 17079 (KR)
(74) Representative: Lavoix
(86) International application number: PCT/KR2017/014915
(87) International publication number: WO 2018/212424

(57) **Abstract**

Provided is a solar power generation unit including: a transporter configured to transport light waves from the sun through a plurality of optical fibers; and a power generator configured to generate electricity by using the light waves incident to the plurality of optical fibers from the transporter, the power generator including a light wave guide configured to arrange the plurality of optical fibers on a plane or a sheet to face a light-incident surface of a solar panel, wherein a plurality of windows are formed in an outer circumferential surface of the plurality of optical fibers, the plurality of windows being configured to refract the light waves progressing therethrough such that the light waves are forwarded to the solar panel.

## Description

### TECHNICAL FIELD

One or more embodiments relate to a solar power generation unit using optical fibers and a power generation system implementing the solar power generation unit, and more particularly, to a solar power generation unit using a plastic optical fiber (POF) array sheet and a solar cell corresponding to the POF array sheet, and a power generation system implementing the solar power generation unit.

### BACKGROUND ART

Solar power generation using sunlight, which is a limitless energy source, uses a panel or a sheet, in which a plurality of solar cells are provided in a structure to which the sunlight having high energy is incident. A solar power generation system does not have high photoelectric transformation efficiency, and thus, for high-capacity power generation, a very large installation area is required.

Sunlight has a very wide wavelength range, which includes a visible light region of 400 to 700 nm. Sunlight has varying intensities based on the wavelength range. Currently, a high-purity crystalline silicon-based solar panel, which is generally used for solar power generation, absorbs about 90% of the wavelength range of 500 to 800 nm, and has low efficiency or little absorption with respect to other wavelengths.

Solar panel units of the solar power generation system are divided into a direct-type, in which the solar panel is directly illuminated by sunlight which reaches a plane of the solar panel directly, and a condensing-type, in which a reflective mirror or a condensing lens is used in a solar panel. A solar power generation facility mounted on a rooftop of a building or on the ground mainly uses the direct-type, but the direct-type has a lower efficiency than the condensing-type using a lens or a mirror. The condensing-type which compensates for the disadvantages of the direct-type has to include a complex optical structure and a supporting structure thereof. Thus, these previous solar panels require a high manufacturing cost, and reduction of the lifespan thereof due to high concentration of light is inevitable.

### DESCRIPTION OF EMBODIMENTS

### TECHNICAL PROBLEM

Provided are a solar power generation unit capable of significantly reducing an occupied area and greatly increasing power generation efficiency; and a power generation system implementing the solar power generation unit.

Provided are a solar power generation unit having a low manufacturing cost and reduced installation expenses; and a solar power generation system implementing the solar power generation unit.

Provided are a solar power generation unit capable of effectively protecting a solar panel from thermal shocks and increasing the lifespan of the solar panel; and a solar power generation system implementing the solar power generation unit.

### SOLUTION TO PROBLEM

According to an aspect of the present disclosure, a solar power generation unit includes: a transporter configured to transport light waves from the sun through a plurality of optical fibers; and a power generator configured to generate electricity by using the light waves incident to the plurality of optical fibers from the transporter, the power generator including: a solar panel configured to generate electricity through the light waves; and a light wave guide configured to arrange the plurality of optical fibers on a plane or a sheet to face a light-incident surface of the solar panel, wherein a plurality of windows are formed in an outer circumferential surface of the plurality of optical fibers facing the light-incident surface of the solar panel, the plurality of windows being configured to refract the light waves progressing therethrough such that the light waves are forwarded to the solar panel.

At least one of the plurality of optical fibers may include a first portion and a second portion, an end of the first portion and an end of the second portion may be connected to each other and the light waves may be incident to the other end of the first portion and the other end of the second portion, and the plurality of windows may be formed in the first portion and the second portion of the plurality of optical fibers.

The solar panel and the plurality of optical fibers may be apart from each other by a distance (d) that is arbitrarily set.

The solar panel and the plurality of optical fibers may be apart from each other by a distance (d) of 0.8 mm to 1.4 mm.

The plurality of optical fibers may include a core and a clad covering the core, the plurality of windows may be formed in the clad, and a surface of the core may be exposed at bottoms of the plurality of windows.

The light wave guide may further include a fixing plate configured to fix the plurality of optical fibers, and a ditch-type channel into which the plurality of optical fibers may be inserted is formed in the fixing plate.

The fixing plate may have a reflection function of reflecting the light waves from the plurality of optical fibers to the solar panel.

According to an aspect of the present disclosure, a solar power generation system includes: a multi-power generator in which power generators of a plurality of solar power generation units are integrated; a multi-transporter in which transporters of the plurality of solar power generation units are integrated; and an optical system configured to concentrate sunlight to the multi-transporter, wherein the plurality of solar power generation units include: a light wave transporter including a plurality of optical fibers configured to transport light waves from the sunlight in a direction; and the power generators configured to generate power by using the light waves incident to the plurality of optical fibers of the light wave transporter, the power generators including: a solar panel configured to generate electricity via the light waves; and a light wave guide configured to arrange the plurality of optical fibers on a plane or a sheet to face a light-incident surface of the solar panel, wherein a plurality of windows are formed on an outer circumferential surface of the plurality of optical fibers, the plurality of windows being configured to refract the light waves progressing therethrough such that the light waves are forwarded to the solar panel.

The solar power generation system may further include a cooling device configured to cool the multi-transporter including a light-wave incident unit into which the light waves are incident.

At least one of the plurality of optical fibers may include a first portion and a second portion, an end of the first portion and an end of the second portion may be connected to each other and the light waves may be incident to the other end of the first portion and the other end of the second portion, and the plurality of windows may be formed in the first portion and the second portion of the plurality of optical fibers.

The solar panel and the plurality of optical fibers may be apart from each other by a distance (d) that is arbitrarily set.

The solar panel and the plurality of optical fibers may be apart from each other by a distance (d) of 0.8 mm to 1.4 mm.

The plurality of optical fibers may include a core and a clad covering the core, the plurality of windows may be formed in the clad, and a surface of the core may be exposed at bottoms of the plurality of windows.

The light wave guide may further include a fixing plate configured to fix the plurality of optical fibers, and a ditch-type channel into which the plurality of optical fibers may be inserted is formed in the fixing plate.

The fixing plate may have a reflection function of reflecting the light waves from the plurality of optical fibers to the solar panel.

### ADVANTAGEOUS EFFECTS OF DISCLOSURE

According to one or more embodiments, a solar power plant and small- and medium-sized power generation systems with significantly reduced mobility, expenses, and installation areas, as well as high capacity, may be publicly provided. In particular, environmental destruction that is caused to provide a large area for installation of previous solar power plants, and the increase in maintenance expenses due to a decreased lifespan due to changes in the surrounding environment may be innovatively improved. In particular, there is a wide range of fields of application, including in household solar power electricity, solar power generation in a region in which it is difficult to obtain a site, space engineering, a large vessel, electric cars, portable electric products, etc.

### BRIEF DESCRIPTION OF DRAWINGS

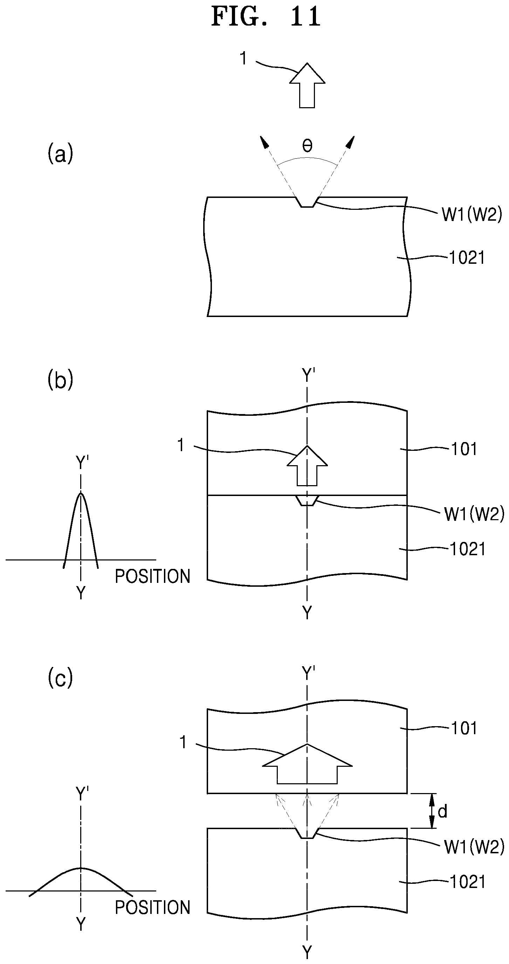

FIG. 1 schematically illustrates a solar power generation unit according to one or more embodiments.
FIG. 2 schematically illustrates a light wave path in a power generator of a solar power generation unit, according to one or more embodiments.
FIG. 3 illustrates a schematic structure of a light wave guide of a solar power generation unit, according to one or more embodiments.
FIG. 4 is a partial view of a fixing plate of a solar power generation unit, according to one or more embodiments.
FIG. 5 is a cross-sectional view showing an example of a state in which an optical fiber and a solar panel are apart from each other in a state in which a fixing plate and the solar panel are coupled to each other in a solar power generation unit, according to one or more embodiments.
FIG. 6 illustrates a detailed structure of an optical fiber in a solar power generation unit, according to one or more embodiments.
FIG. 7 is a schematic longitudinal cross-sectional view for explaining progression of a light wave through an optical fiber and an output of the light wave through a window in a solar power generation unit, according to one or more embodiments.
FIG. 8 is a photograph of actual light emission through a window of an optical fiber according to one or more embodiments.
FIG. 9 is a perspective view of a portion of an optical fiber for explaining emission of a light wave through a window of an optical fiber in a solar power generation unit, according to one or more embodiments.
(a) and (b) of FIG. 10 are respectively a cross-sectional view and a longitudinal cross-sectional view illustrating an example of the emission of the light wave through the window of the optical fiber illustrated in FIG. 9.
(a) of FIG. 11 illustrates an example of output of a light wave through a window formed in an optical fiber, (b) of FIG. 11 illustrates an example of an incident form of the light wave when the optical fiber is tightly joined to a solar panel, and (c) of FIG. 11 illustrates an example of an incident form of the light wave when the optical fiber and the solar panel are apart from each other by a certain distance.

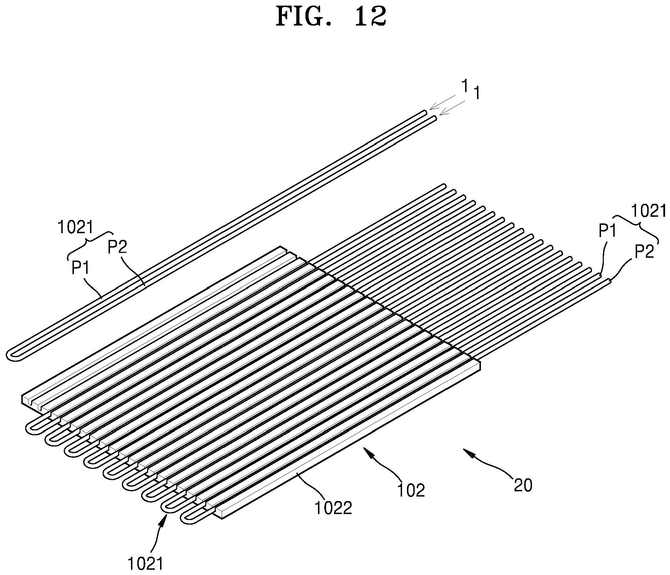

FIG. 12 illustrates a schematic structure of a light wave guide of a solar power generation unit, according to one or more embodiments.

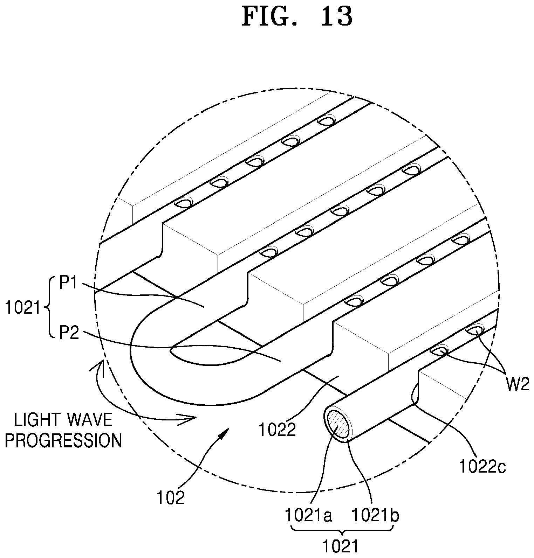

FIG. 13 is a view of a portion of a fixing plate illustrated in FIG. 12 in a solar power generation unit, according to one or more embodiments.

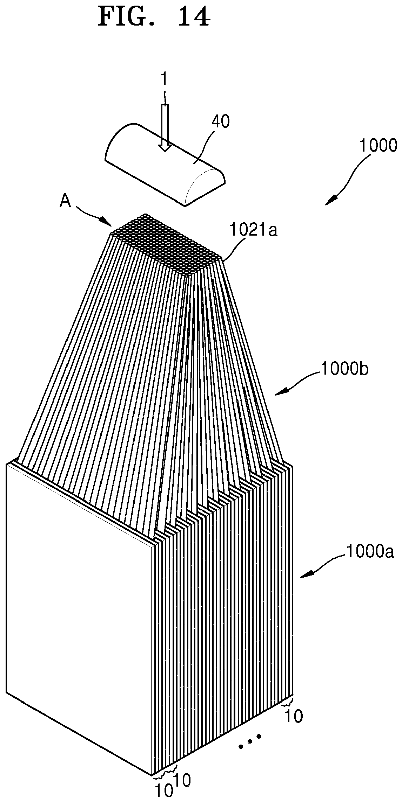

FIG. 14 illustrates an example of a solar power generation system according to the present disclosure, in accordance with a solar power generation unit, according to one or more embodiments.

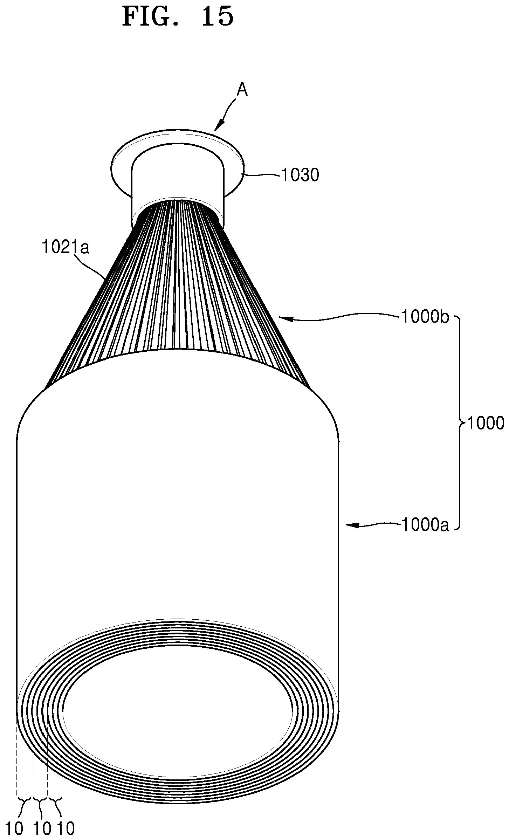

FIG. 15 illustrates an example of a solar power generation system according to the present disclosure, in accordance with a solar power generation unit, according to one or more embodiments.

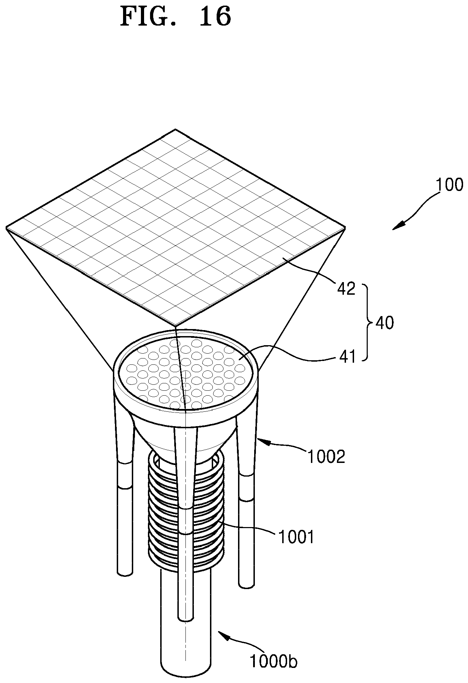

FIG. 16 illustrates an example of an upper structure of a power generation system in which a light wave transporter has a cooling structure, according to one or more embodiments.
   An upper structure of a power generation system 1000 in which a light wave transporter has a cooling structure in the power generation system illustrated in FIGS. 14 and 15 is illustrated.

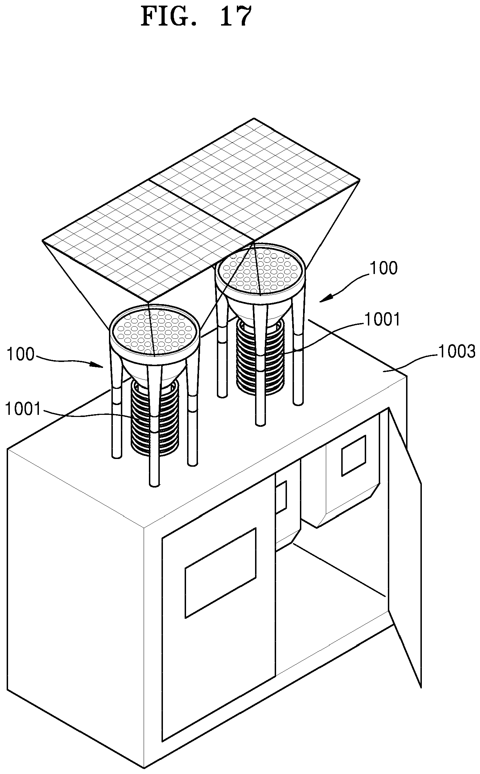

FIG. 17 illustrates an example of a cooling system applied to a solar power generation system, according to one or more embodiments.

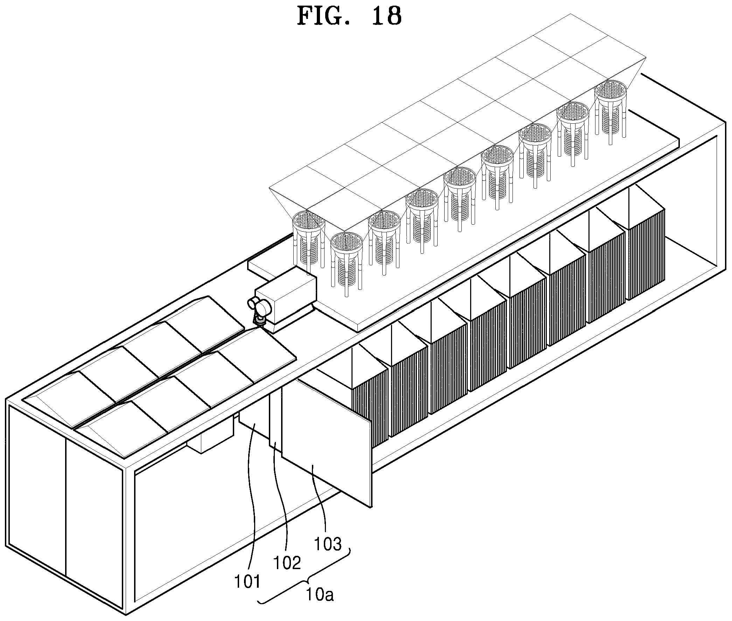

FIG. 18 illustrates an example of a solar power generation system in accordance with a solar power generation unit, according to one or more embodiments.

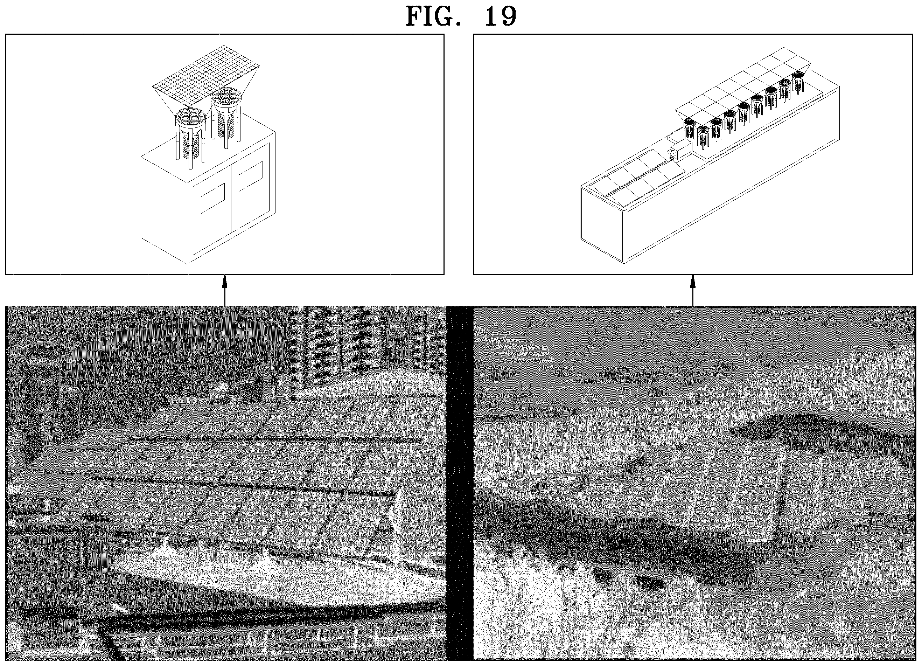

FIG. 19 illustrates by comparison that the power generation system illustrated in FIGS. 17 and 18 is capable of replacing a previous power generation system requiring an installation space and site having a large area.

### MODE OF DISCLOSURE

Hereinafter, one or more embodiments of the present disclosure will be described in detail by referring to the accompanying drawings. The present disclosure may, however, be embodied in many different forms and should not be construed as being limited to the embodiments set forth herein; rather these embodiments are provided so that this disclosure will thorough and complete, and will fully convey the present disclosure to one of ordinary skill in the art. Like reference numerals refer to the like elements throughout. Further, various elements and regions in the drawings are schematically illustrated. Thus, the present disclosure is not limited to the relative size or distance illustrated in the accompanying drawings.

It will be understood that, although the terms first, second, etc. may be used herein to describe various elements, these elements should not be limited by these terms. These terms are only used to distinguish one element from another element. For example, a first element could be termed a second element, and on the contrary, a second element could be termed a first element without departing from the teachings of exemplary embodiments.

The terminology used herein is for the purpose of describing particular embodiments only and is not intended to be limiting of exemplary embodiments. As used herein, the singular forms "a," "an" and "the" are intended to include the plural forms as well, unless the context clearly indicates otherwise. It will be further understood that the terms "comprises" and/or "comprising" used herein specify the presence of stated features, integers, steps, operations, members, components, and/or groups thereof, but do not preclude the presence or addition of one or more other features, integers, steps, operations, members, components, and/or groups thereof.

Unless otherwise defined, all terms including technical and scientific terms used herein have the same meaning as commonly understood by one of ordinary skill in the art to which exemplary embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the accompanying drawings, variations from the shapes of the illustrations as a result, for example, of manufacturing techniques and/or tolerances, are to be expected. Thus, exemplary embodiments should not be construed as limited to the particular shapes of regions illustrated herein but may be to include deviations in shapes that result, for example, from manufacturing. As used herein, the term "and/or," includes any and all combinations of one or more of the associated listed items.

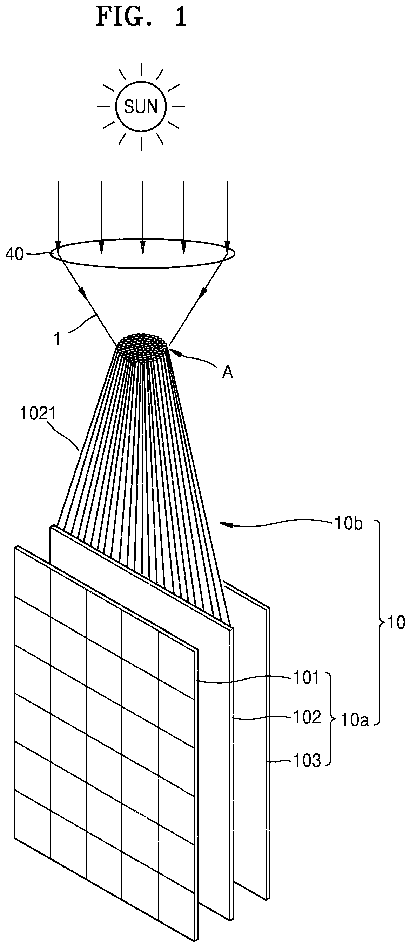

FIG. 1 schematically illustrates a solar power generation system using a solar power generation unit 10 according to one or more embodiments.

In the drawing, a reference numeral 10a indicates a power generator 10a generating electricity through a light wave, and a reference numeral 10b indicates a light wave transporter 10b including an optical fiber transporting, to the power generator 10a, the light wave, which is a power generating energy.

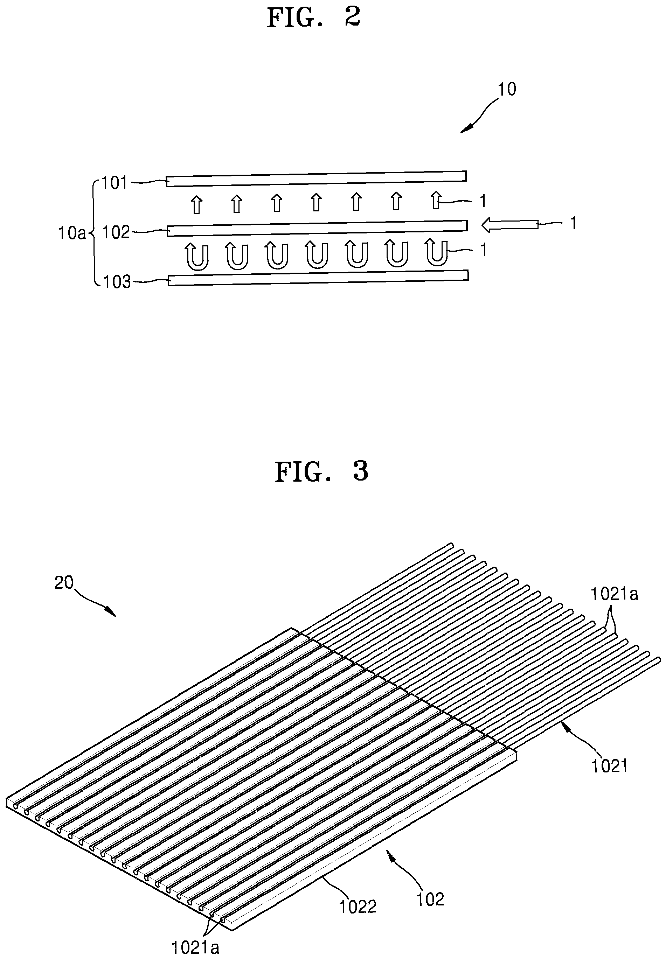

In detail, a reference numeral "101" included in the power generator 10a indicates a photovoltaics (PV) or copper indium galium selenide (CIGS) based-solar panel or solar cell (hereinafter, generally referred to as a solar panel), and a reference numeral "102" indicates a light wave guide injecting or projecting the light wave 1 supplied from the sun through the light wave transporter 10b, in a direction perpendicular to a light incident surface of the solar panel 101. A front surface of the light wave guide 102 corresponding to the solar panel 101 indicates a solar panel mounting portion. Also, a reflection plate 103 preventing a loss of the light wave 1 by reflecting the light wave progressing toward a rear side of the light wave guide 102 toward the solar panel 101 and having a high reflectivity, for example, a reflectivity of 95% or greater may be provided at a rear surface of the light wave guide 102. Here, the reflection plate 103 may be an optional component, and the function of the reflection plate 103 may be provided by fixing plates 1022 (FIG. 3) to be described later.

In the solar power generation system briefly described above, a solar light wave condensed by using a plurality of optical fibers arranged in a flat surface or a curved surface, may be guided into a direction and the light wave progressing along the plurality of optical fibers may be refracted in a direction different from the direction in which the light wave progressed, that is, a direction that is approximately perpendicular to the direction in which the light wave progressed.

Referring to FIG. 1, the light wave guide 102 includes the plurality of optical fibers 1021 arranged in parallel to each other, ends of the plurality of optical fibers 1021 extending to the outside of the light wave guide 102 are combined into a bunch to form the light wave transporter 10b, and a light wave incident unit A is provided at a front end surface of the light wave transporter 10b having the form of a bunch. The light wave incident unit A is located on a certain plane on which sections of the optical fibers 1021 are located, and on this plane, the light wave 1 from the sun is concentrated to a light wave incident area via the lens optical system 40. Here, a cooling device for preventing deformation of or damage to the optical fibers due to heat concentrated in the light wave incident unit A may be provided around the bunch of the optical fibers at which the light wave incident unit A is provided. This aspect will be described later.

Referring to FIG. 2, the light wave guide 102 included in the power generator 10a is a surface light source or a surface illuminant using an external light source, rather than a self luminescence type, and allows the light wave 1 injected in a direction parallel to the plane thereof to be projected or refracted in a direction approximately perpendicular to the plane, so as to be incident into the solar panel 101. Also, the reflection plate 103 located at a rear end of the light wave guide 102 reflects the light wave 1 progressing toward the rear end of the light wave guide 102, toward the solar panel 101.

In FIGS. 1 and 2, the solar panel 101, the light wave guide 102, and the reflection plate 103 are illustrated in a state in which the solar panel 101, the light wave guide 102, and the reflection plate 103 are separated from one another, for convenience of understanding. However, in reality, the solar panel 101, the light wave guide 102, and the reflection plate 103 are tightly joined to one another as a sandwich shape.

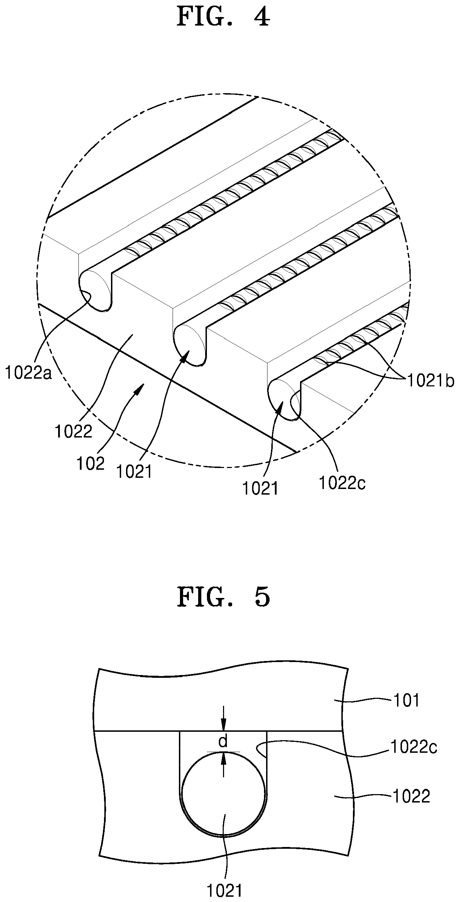

The light wave guide 102 has a form of a planar light source configured to emit the light wave 1 injected through an edge surface of the planar light wave guide 102 in a direction perpendicular to the plane thereof, and FIGS. 3 and 4 schematically illustrate a structure of the light wave guide 102.

Referring to FIGS. 3 and 4, the light wave guide 102 includes the plurality of optical fibers 1021 arranged in parallel to each other and the fixing plate 1022 supporting the plurality of optical fibers 1021 as a sheet shape or on a plane.

The fixing plate 1022 is configured to maintain the sheet shape or the plane shape of the plurality of optical fibers 1021 arranged in a certain distance from each other and to form one plane with the plurality of optical fibers 1021 or a light wave guide sheet on the plurality of optical fibers 1021.

An ultraviolet blocking layer may be formed on a surface of the optical fibers 1021, and a diameter of the ultraviolet blocking layer may be about 0.1 mm to about 1.5 mm. The optical fibers 1021 may be arranged in a single direction in parallel to each other by a strand, and a distance between the optical fibers 1021 may be between 0.1 mm and 0.8 mm. The ultraviolet blocking layer coated on the optical fibers 1021 may have a thickness of 0.05 to 0.09 mm. The optical fibers may be glass or plastic optical fibers. Windows or prism units as an emission unit for forwarding the light wave progressing along the inside core, to the solar panel, by refracting the light wave to the outside, or windows may be formed in the optical fibers 1201 at a constant interval, and this aspect will be described later.

The plastic optical fibers may include a core including high purity polymethyl methacrylate (PMMA) and a thin clad layer including fluorine polymethyl methacrylate (F-PMMA). A depth of a channel 1022c formed in the fixing plate 1022 may correspond to a depth into which a portion of the outer circumferential surface of the optical fibers 1021 may be guided, for example, a depth of 0.006 to 0.1 mm. Also, the reflection plate 103, which is an optional component, may have a thickness of 0.1 mm to 1.5 mm.

A lower portion of the optical fibers 1021 is fixed to the fixing plate 1022. To this end, as illustrated in FIGS. 4 and 5, a ditch or the channel 1022c to which the optical fibers 1021 are fixed is formed on an upper surface of the fixing plate 1022. Here, a depth of the channel 1022c is greater than a diameter of the optical fibers 1021, and thus, a surface of the optical fibers 1021 is located at a lower portion of an opening of the channel 1022c. Thus, as illustrated in FIG. 5, when the fixing plate 1022 is tightly fixed to the solar panel 101, the surface of the optical fibers 1021 may be apart from an incident surface (a lower surface in the drawing) of the solar panel 101 by a certain distance d. Like this, when the optical fibers 1021 are apart from the solar panel 101 by the certain distance d, the solar panel 101 to which the light from the optical fibers 1021 is incident may be protected. However, according to another embodiment, the optical fibers 1021 may be tightly joined (d=0) to the solar panel 101.

In the present embodiment, a side portion of the plurality of optical fibers is fixed to the fixing plate 1022 having a square shape, and the other side portion of the plurality of optical fibers extends freely and separately by a strand. Thus, the fixing plate 1022 basically has a size corresponding to the solar panel 101.

The fixing plate 1022 may have the function of the reflection plate 103 described above, and thus, the fixing plate 1022 may not only fix the optical fibers 1021, but may also reflect the light wave from the optical fibers to the solar panel to increase light use efficiency. The reflection function of the fixing plate 1022 may be obtained through interface reflection based on a difference in refractive index between materials of the optical fibers 1021 and the fixing plate 1022, or may be obtained by coating a bottom surface of the channel 1022c with a reflection material layer (not shown). The reflection function may be variously realized by using various techniques currently existing, and thus, the technical scope of the present disclosure is not limited by a specific technique for realizing the reflection function.

Meanwhile, according to another embodiment, the fixing plate 1022 may have an extended structure for supporting the entirety of the optical fibers 1021.

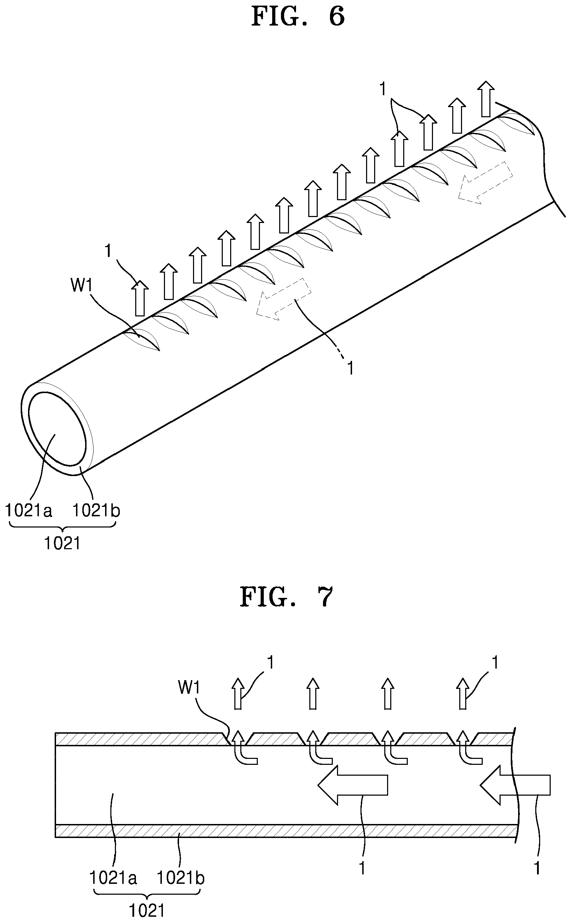

As illustrated in FIGS. 6 and 7, the optical fibers 1021 includes a core 1021a and a clad 1021b surrounding the core 1021a. A window W1 is formed in the clad 1021b, wherein the light wave progressing along the core 1021a is emitted through the window W1, which is not covered by the clad inducing a guide of the light wave in the core.

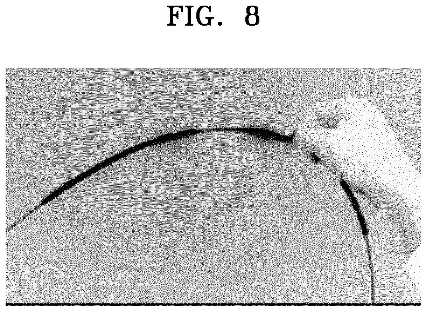

The window W1 is located in the light wave emission area as described above, and may be formed to have a slit shape with a V-cut by mechanical processing, such as diamond cutting, or may be formed to have a circular shape by drilling. The window W1 is formed in the clad 1021b to expose a surface of the core 1021a as illustrated in FIG. 7. The window W1 emits the light wave 1 progressing inside the core 1021a in a direction perpendicular to the progressing direction, and is formed in the clad 1021a of the optical fibers 1021 in a multiple number at an appropriate distance and depth, which may be adjusted via a design specification. FIG. 8 illustrates a real emission scene through the window in the optical fibers according to the present disclosure.

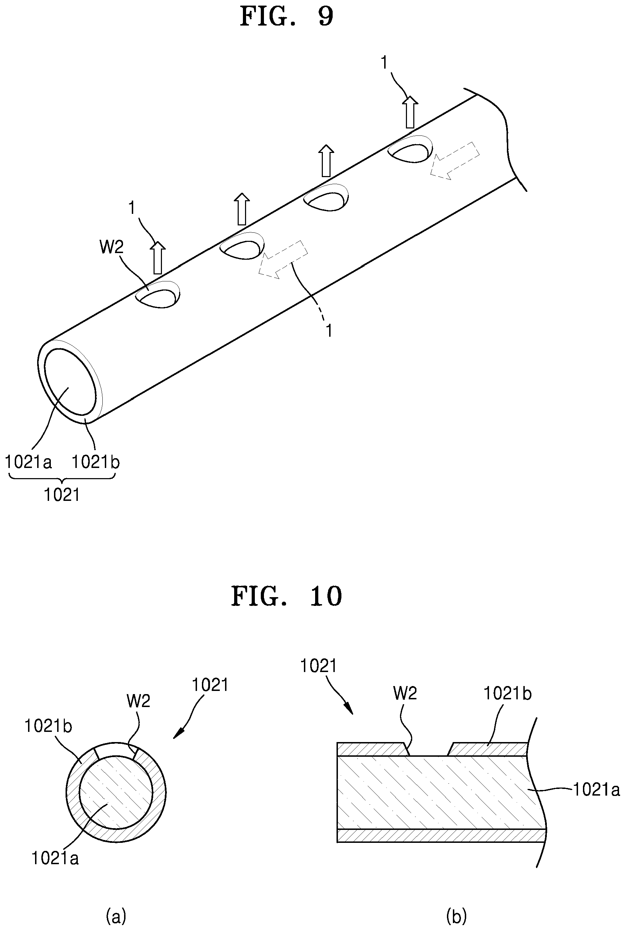

FIG. 9 illustrates optical fibers according to another embodiment. FIG. 9 is an extracted perspective view of the optical fibers 1021, on a surface of which a plurality of windows W2 emitting the light wave are formed at a constant interval, and FIG. 10 is a sectional view of the optical fibers 1021, wherein (a) and (b) of FIG. 10 are respectively a longitudinal-sectional view and a cross-sectional view of a structure of the windows W2.

As illustrated in FIGS. 9 and 10, the optical fibers 1021 include the core 1021a and the clad 1021b surrounding the core 1021a. The windows W2 are formed in the clad 1021b, the windows W2 being an emission unit for allowing the light wave 1 progressing along the core 1021a inside the clad 1021b to be emitted in a direction perpendicular to the progression direction. The windows W2 may be formed by using a chemical method, a laser cutting operation or a diamond cutting operation, as described above.

According to the present embodiment, the windows W2 are formed in the clad 1021b to expose a surface of the core 1021a as illustrated in FIG. 10, and it is required to prevent or minimize the damage to the surface of the core 1021a, when processing the windows W2. When the surface of the core 1021a, in particular, the surface of the core 1021a, the surface being exposed to inner bottom portions of the windows W2, becomes rough, optical loss due to a negative factor, such as light scattering or absorption in this portion, may occur, so that an output of the light wave through the windows W2 may be reduced.

FIG. 10 compares states in which the light wave is incident between a case in which the optical fibers 1021 are tightly joined to the solar panel 101 (d=0) and a case in which the optical fibers 1021 are apart from the solar panel 101 (d>0).

(a) of FIG. 8 illustrates the state in which the light wave 1 is emitted through the windows W1 and W2 of the optical fibers 1021 and is scattered. When the light wave 1 progressing along the core meets the windows W1 and W2 formed in the clad 1021b, a portion of the light wave 1 is emitted to the solar panel 101 through the windows W1 and W2. Here, the light wave 1 is incident to the solar panel 101 by being diverged by a certain angle θ. According to an experiment, the divergence of the light wave 1 maintains approximately plus or minus 17 degrees. When, like this case (c), the solar panel 101 is apart from the optical fibers 1021 by a certain distance when the light wave 1 is diverged, compared to a case (b) when the solar panel 101 is tightly joined to the optical fibers 1021, an area (a size of a spot) of the solar panel 101, to which the light wave is incident, is increased. This denotes that in the case (b), the light wave 1 is incident to a small area of the solar panel 101 so that a small incident area (spot) is formed, and in the case (c), the light wave 1 is diverged while progressing through the certain distance d and is incident into a relatively greater area to form a relatively greater incident area. Accordingly, in the case (b) when the optical fibers 1021 are tightly joined to the solar panel 101, a peak intensity of the light in the incident area of the solar panel 101 is maintained to be very much higher compared to that of the case (c) when the optical fibers 1021 are not tightly joined to the solar panel 101.

When the solar power generation is continued and the state is maintained for a long time, in which an optical spot of a high energy is locally concentrated to the solar panel, a local defect, for example, a change of property or cracks, may occur in the solar panel 101. Thus, when it is required to prevent the damage to the solar panel due to the peak intensity, it is needed that the optical fibers 1021 be apart from the solar panel 101 by a certain distance d in order to increase the incident area through which the light is incident to the solar panel 101 and to reduce the peak intensity so that the solar panel 101 is protected. According to results of various experiments related to this, photoelectric transformation efficiency may be improved, when there is a distance of 0.8 to 1.2 mm to appropriately decrease the peak intensity of the incident light and also to increase the incident area (the size of the spot) formed through the window W1 or W2.

Meanwhile, according to another embodiment of the present disclosure, a structure for efficiently using the light wave is provided.

Referring to FIGS. 12 and 13, the optical fibers 1021 fixed to the channel 1022c of the fixing plate 1022 have a first portion P1 and a second portion P2, which are parallel to each other and providing two paths which are bent to have a U-shape and through which the light wave progresses. The light wave 1 is incident to front ends of the first portion P1 and the second portion P2 in the same direction. Thus, the light wave 1 incident to the both front ends of the optical fibers 1021 progresses through the first portion P1 and the second portion P2, and in this process, most of the light wave 1 is emitted to the solar panel 101 through the window W2 provided in the first portion P1 and the second portion P2.

This structure allows a greater portion of the light wave to be incident to the solar panel by allowing the light wave used, for example, in the first portion P1 to progress through the other portion, for example, the second portion P2, thereby increasing the light wave use efficiency.

As described above, a plurality of the solar power generation units 10 may be integrated to form a generation system having a high power generation capacity.

FIG. 14 schematically illustrates a solar power generation system 1000 according to the present disclosure, wherein the solar power generation system 1000 includes a multi-power generator 1000a having a structure in which the plurality of solar power generation units 10 are integrated (stacked) in a direction.

The multi-power generator 1000a is realized as the structure in which the plurality of power generation units including the solar panel 101, the light wave guide 102, and the reflection plate 103 are stacked. Here, the optical fibers 1021 of each of the solar power generation units 10 are gathered in a bunch to form one multi-light wave transporter 1000b, and front ends of the optical fibers of the multi-light wave transporter 1000b are located on an arbitrary plane to form a light wave incident surface of the light wave incident unit A. The light wave incident unit A may cut sections of the optical fibers 1021 gathered in a bunch as described above by using a diamond wet grinder and may perform mirror finishing by using a polishing member. The light wave 1 from the sun is concentrated to the light wave incident unit A by the lens optical system 40.

In the present embodiment, the lens optical system 40 denotes both a unit lens optical system for concentrating the solar light wave and a multi-lens optical system including a plurality of lenses, and the technical scope of the present disclosure is not limited to a specific optical structure. According to an embodiment of the present disclosure, a first lens optical system including a single convex lens or a convex lens array for concentrating the light wave to the light wave incident unit, and a second lens optical system including a single Fresnel lens or a Fresnel lens array for converging the sun light to the second lens optical system may be provided.

Meanwhile, the power generation system according to the present disclosure may be realized as a cylindrical shape as illustrated in FIG. 15.

This is a unit power generation system described above, that is, a power generation system including a power generator having a cylindrical shape, the power generator being formed by stacking the solar power generation units 10 on a plane in one direction and rolling the solar power generation units 10.

The multi-generator 1000a of the power generation system 1000 including the plurality of solar power generation units in FIG. 15 has the cylindrical shape, and the cylindrical generator 1000a is a gathered object of unit power generation systems roundly rolled to have a growth ring or spiral shape, that is, the solar power generation units 10. The light wave incident surface or the light wave incident unit A which is mirror-finished as described above is provided at a front end of the light wave transporter 1000b at which the front end of all of the optical fibers 1021 of the solar power generation units 10 gathered in the cylindrical shape, the optical fibers 1021 being altogether gathered, is integrated into a bunch by a cylindrical optical fiber fixing unit 1030.

FIG. 16 illustrates an upper structure of the power generation system 100 having a cooling structure of the light wave transporter 1000b. The power generation system 100 of FIG. 16 includes a first lens system 41 of the lens optical system 40, and the light wave transporter 1000b which is coupled to the first lens system 41 by the fixing structure 1002. The power generator 1000a having the shape illustrated in FIGS. 14 and 15 may be provided at a lower end of the light wave transporter 1000b. A cooling device 1001 is mounted around the light wave transporter 1000b.

Meanwhile, the lens optical system 40 may include a plurality of lens systems. According to the present embodiment, the lens optical system 40 includes the first lens system 41 described above and a second lens system 42 corresponding to the first lens system 41. For example, the first lens system 41 may include an array of a plurality of convex lenses and the second lens system 42 may include a Fresnel lens array.

The optical fiber fixing unit 1003 is a cylindrical structure having a constant length and a constant diameter and including a material, such as metal, glass, or ceramics, and gaps between the optical fibers are waterproofed at the mirror-finished light wave incident unit A.

The cooling device 1001 has a structure of a cooling water cyclic coil, and may cool the front end of the optical fibers including the light wave incident unit A, to which a high temperature heat energy is concentrated, by using this structure, to maintain the temperature of this area at a range of 5 to 80 degrees, thereby preventing deformation of or damage to the optical fibers due to high heat. According to another embodiment, the cooling device 1001 may be applied not only to the bunch of optical fibers (the integrated optical fibers 1000a) of the multi-transporter, but also to other components required to be cooled.

A relative position of the Fresnel lens array of the second lens system 42 for initially focusing the light wave from the sun, the relative position being with respect to the first lens system 41, is fixed by an additional structure.

FIG. 17 illustrates a structure in which a plurality of generators 1000a are included in a cabinet 1003, and illustrates an example of the solar power generation system in which the cooling device 1001 illustrated in FIG. 16 is included. This is an example of an urban-type power generation system requiring power of 10Kw or less, and FIG. 18 illustrates an example of a large solar power generation system of 300Kw or greater.

The system illustrated in FIG. 18 may include not only all elements needed for solar power generation, but also a facility for cooling these elements and a system managing and controlling generated electricity. Like the power generation system illustrated in FIG. 17, the power generation system illustrated in FIG. 18 may have the stack structure on a plane described in FIG. 1, that is, a sandwich structure in which the solar panel 101, the light wave guide 102, and the reflection plate 103 are multiply stacked.

In order to alleviate a high temperature heat concentration of the optical lens system, a cold mirror reflecting ultraviolet rays of 200 nm to 380 nm and visible rays of 381 nm to 650 nm and allowing infrared rays of 651 nm or greater to pass therethrough may be implemented. This is effective for preventing deformation of or damage to the optical fibers due to high temperature.

FIG. 19 is a view showing by comparison that the power generation system according to the present disclosure, which is illustrated in FIGS. 17 and 18, may replace the previous power generation system requiring a large mounting space and site.

While the present disclosure has been particularly shown and described with reference to example embodiments thereof, it will be understood by one of ordinary skill in the art that various changes in form and details may be made therein without departing from the spirit and scope of the present disclosure as defined by the following claims. Hence, it will be understood that the embodiments described above are not limiting of the scope of the disclosure.

## Claims

1. A solar power generation unit comprising:
a transporter configured to transport light waves from the sun through a plurality of optical fibers; and
a power generator configured to generate electricity by using the light waves incident to the plurality of optical fibers from the transporter,
the power generator comprising:
a solar panel configured to generate electricity through the light waves; and
a light wave guide configured to arrange the plurality of optical fibers on a plane or a sheet to face a light-incident surface of the solar panel,
wherein a plurality of windows are formed in an outer circumferential surface of the plurality of optical fibers facing the light-incident surface of the solar panel, the plurality of windows being configured to refract the light waves progressing therethrough such that the light waves are forwarded to the solar panel.

2. The solar power generation unit of claim 1, wherein at least one of the plurality of optical fibers comprises a first portion and a second portion,
an end of the first portion and an end of the second portion are connected to each other and the light waves are incident to the other end of the first portion and the other end of the second portion, and
the plurality of windows are formed in the first portion and the second portion of the plurality of optical fibers.

3. The solar power generation unit of claim 1, wherein the solar panel and the plurality of optical fibers are apart from each other by a distance (d) that is arbitrarily set.

4. The solar power generation unit of claim 3, wherein the solar panel and the plurality of optical fibers are apart from each other by a distance (d) of 0.8 mm to 1.4 mm.

5. The solar power generation unit of claim 1, wherein the plurality of optical fibers comprise a core and a clad covering the core,
the plurality of windows are formed in the clad, and
a surface of the core is exposed at bottoms of the plurality of windows.

6. The solar power generation unit of claim 1, wherein the light wave guide further comprises a fixing plate configured to fix the plurality of optical fibers, and
a ditch-type channel into which the plurality of optical fibers are inserted is formed in the fixing plate.

7. The solar power generation unit of claim 1, wherein the fixing plate has a reflection function of reflecting the light waves from the plurality of optical fibers to the solar panel.

8. A solar power generation system comprising:
a multi-power generator in which power generators of a plurality of solar power generation units are integrated;
a multi-transporter in which transporters of the plurality of solar power generation units are integrated; and
an optical system configured to concentrate sunlight to the multi-transporter,
wherein the plurality of solar power generation units comprise:
a light wave transporter comprising a plurality of optical fibers configured to transport light waves from sunlight in a direction; and
the power generators configured to generate power by using the light waves incident to the plurality of optical fibers of the light wave transporter,
the power generators comprising:
a solar panel configured to generate electricity via the light waves; and
a light wave guide configured to arrange the plurality of optical fibers on a plane or a sheet to face a light-incident surface of the solar panel,
wherein a plurality of windows are formed in an outer circumferential surface of the plurality of optical fibers, the plurality of windows being configured to refract the light waves progressing therethrough such that the light waves are forwarded to the solar panel.

9. The solar power generation system of claim 8, further comprising a cooling device configured to cool the multi-transporter comprising a light wave-incident unit to which the light waves are incident.

10. The solar power generation system of claim 8, wherein at least one of the plurality of optical fibers comprises a first portion and a second portion,
an end of the first portion and an end of the second portion are connected to each other and the light waves are incident to the other end of the first portion and the other end of the second portion, and
the plurality of windows are formed in the first portion and the second portion of the plurality of optical fibers.

11. The solar power generation system of claim 8, wherein the solar panel and the plurality of optical fibers are apart from each other by a distance (d) that is arbitrarily set.

12. The solar power generation system of claim 11, wherein the solar panel and the plurality of optical fibers are apart from each other by a distance (d) of 0.8 mm to 1.4 mm.

13. The solar power generation system of claim 8, wherein the plurality of optical fibers comprise a core and a clad covering the core,
the plurality of windows are formed in the clad, and
a surface of the core is exposed at bottoms of the plurality of windows.

14. The solar power generation system of claim 8, wherein the light wave guide further comprises a fixing plate configured to fix the plurality of optical fibers, and
a ditch-type channel into which the plurality of optical fibers are inserted is formed in the fixing plate.

15. The solar power generation system of claim 8, wherein the fixing plate has a reflection function of reflecting the light waves from the plurality of optical fibers to the solar panel.

## Amended claims

### Amended claims under Art. 19.1 PCT

1. A solar power generation unit comprising:
a transporter configured to transport light waves from the sun through a plurality of optical fibers; and
a power generator configured to generate electricity by using the light waves incident to the plurality of optical fibers from the transporter,
the power generator comprising:
a solar panel configured to generate electricity through the light waves; and
a light wave guide configured to arrange the plurality of optical fibers on a plane or a sheet to face a light-incident surface of the solar panel,
wherein a plurality of windows are formed in an outer circumferential surface of the plurality of optical fibers facing the light-incident surface of the solar panel, the plurality of windows being configured to refract the light waves progressing therethrough such that the light waves are forwarded to the solar panel, and
the solar panel and the plurality of optical fibers are apart from each other by a distance (d) that is arbitrarily set, in order to prevent a local defect in the solar panel due to local concentration of the light waves on the solar panel.

2. The solar power generation unit of claim 1, wherein at least one of the plurality of optical fibers comprises a first portion and a second portion,
an end of the first portion and an end of the second portion are connected to each other and the light waves are incident to the other end of the first portion and the other end of the second portion, and
the plurality of windows are formed in the first portion and the second portion of the plurality of optical fibers.

3. (canceled)

4. The solar power generation unit of claim 1, wherein the solar panel and the plurality of optical fibers are apart from each other by a distance (d) of 0.8 mm to 1.4 mm.

5. The solar power generation unit of claim 1, wherein the plurality of optical fibers comprise a core and a clad covering the core,
the plurality of windows are formed in the clad, and
a surface of the core is exposed at bottoms of the plurality of windows.

6. The solar power generation unit of claim 1, wherein the light wave guide further comprises a fixing plate configured to fix the plurality of optical fibers, and
a ditch-type channel into which the plurality of optical fibers are inserted is formed in the fixing plate.

7. The solar power generation unit of claim 1, wherein the fixing plate has a reflection function of reflecting the light waves from the plurality of optical fibers to the solar panel.

8. A solar power generation system comprising:
a multi-power generator in which power generators of a plurality of solar power generation units are integrated;
a multi-transporter in which transporters of the plurality of solar power generation units are integrated; and
an optical system configured to concentrate sunlight to the multi-transporter,
wherein the plurality of solar power generation units comprise:
a light wave transporter comprising a plurality of optical fibers configured to transport light waves from sunlight in a direction; and
the power generators configured to generate power by using the light waves incident to the plurality of optical fibers of the light wave transporter,
the power generators comprising:
a solar panel configured to generate electricity via the light waves; and
a light wave guide configured to arrange the plurality of optical fibers on a plane or a sheet to face a light-incident surface of the solar panel,
wherein a plurality of windows are formed in an outer circumferential surface of the plurality of optical fibers, the plurality of windows being configured to refract the light waves progressing therethrough such that the light waves are forwarded to the solar panel, and
the solar panel and the plurality of optical fibers are apart from each other by a distance (d) that is arbitrarily set, in order to prevent a local defect in the solar panel due to local concentration of the light waves on the solar panel.

9. The solar power generation system of claim 8, further comprising a cooling device configured to cool the multi-transporter comprising a light wave-incident unit to which the light waves are incident.

10. The solar power generation system of claim 8, wherein at least one of the plurality of optical fibers comprises a first portion and a second portion,
an end of the first portion and an end of the second portion are connected to each other and the light waves are incident to the other end of the first portion and the other end of the second portion, and
the plurality of windows are formed in the first portion and the second portion of the plurality of optical fibers.

11. (canceled)

12. The solar power generation system of claim 8, wherein the solar panel and the plurality of optical fibers are apart from each other by a distance (d) of 0.8 mm to 1.4 mm.

13. The solar power generation system of claim 8, wherein the plurality of optical fibers comprise a core and a clad covering the core,
the plurality of windows are formed in the clad, and
a surface of the core is exposed at bottoms of the plurality of windows.

14. The solar power generation system of claim 8, wherein the light wave guide further comprises a fixing plate configured to fix the plurality of optical fibers, and
a ditch-type channel into which the plurality of optical fibers are inserted is formed in the fixing plate.

15. The solar power generation system of claim 8, wherein the fixing plate has a reflection function of reflecting the light waves from the plurality of optical fibers to the solar panel.

Statement under Art. 19.1 PCT
Claim 1 is amended; Claim 2 is unchanged, Claims 3 is cancelled; Claim 4 is amended; Claims 5-7 are unchanged; Claim 8 is amended; Claims 9-10 is unchanged; Claim 11 is cancelled; Claim 12 is amended; Claims 13-15 are unchanged.
Claim 1 is amended to incorporate the subject matters of Claim 3, and thus supported by Claim 3 as originally filed.
Claim 4 is amended to adjust its dependency from "Claim 3" to "Claims 1", and thus supported by Claim 4 as originally filed.
Claim 8 is amended to incorporate the subject matters of Claim 11, and thus supported by Claim 11 as originally filed.
Claim 12 is amended to adjust its dependency from "Claim 11" to "Claims 8", and thus supported by Claim 12 as originally filed.
